# NEUE EUROPÄISCHE PATENTSCHRIFT

(11) **EP 1 470 747 B2**
(45) Veröffentlichungstag und Bekanntmachung des Hinweises auf die Entscheidung über den Einspruch: **01.12.2021**
(45) Hinweis auf die Patenterteilung: 14.05.2014
(21) Anmeldenummer: 03701466.9
(22) Anmeldetag: 02.01.2003
(51) Int. Cl.: H05K 13/04, H01L 21/67

(54) **CHIPENTNAHMEVORRICHTUNG, BESTÜCKSYSTEM UND VERFAHREN ZUM ENTNEHMEN VON CHIPS VON EINEM WAFER**
CHIP REMOVAL DEVICE CHIP, PLACING SYSTEM AND METHOD FOR REMOVING CHIPS FROM A WAFER
DISPOSITIF DE PRÉLÈVEMENT DE PUCE, SYSTÈME D'ÉQUIPEMENT ET PROCÉDÉ POUR PRÉLEVER DES PUCES D'UNE PLAQUETTE

(30) Priorität: 30.01.2002 DE 10203601
(43) Veröffentlichungstag der Anmeldung: 27.10.2004
(73) Patentinhaber: ASM Assembly Systems GmbH & Co. KG, 81379 München (DE)
(72) Erfinder: KWAN, Yim Bun, Patrick, 73431 Aalen (DE)
(74) Vertreter: Dilg, Haeusler, Schindelmann Patentanwaltsgesellschaft mbH
(86) Internationale Anmeldenummer: PCT/DE2003/000003
(87) Internationale Veröffentlichungsnummer: WO 2003/065783

(56) Entgegenhaltungen:
- WO-A1-00/69241
- DE-U- 9 407 004
- JP-A- 8 162 502
- US-A- 4 372 802
- US-A- 4 626 167

## Beschreibung

Die Erfindung betrifft eine Chipentnahmevorrichtung, ein Chipentnahmesystem, ein Bestücksystem sowie ein Verfahren zum Entnehmen von Chips von einem Wafer, bei welchem die Chips direkt von einem Halbleiter-Wafer entnommen werden.

Mit steigender Verringerung der Gehäusegröße und der Montagekosten wird das Aufbringen von Halbleiterplättchen direkt auf ein Substrat entweder in gewendeter Ausrichtung als Flip-Chip oder in nichtgewendeter Ausrichtung auf Substraten immer wichtiger. Daher weisen die neuesten Entwicklungen von Zuführvorrichtungen für SMT-Applikationen sowohl die Möglichkeit auf, COB (chip-on-board), als auch FCOB (flip-chip-on-board) Bauelemente zu verarbeiten. Die bekannten Entwürfe derartiger Zuführvorrichtungen weisen einen gewöhnlichen Pick-and-Place Mechanismus auf, von welchem die Chips von einem Halbleiter-Wafer entnommen werden können. Zusätzlich ist bei den bekannten Zuführvorrichtungen eine Wendestation vorgesehen, an welche die entnommenen Chips zum Wenden derselben übergeben werden müssen.

Derartige Vorschläge sind beispielsweise aus der US 6, 171, 049 sowie aus der US 6,173,750 bekannt. Beide Vorschläge weisen jedoch den Nachteil auf, dass einerseits das Aufnehmen von Chips von dem Wafer und das Wenden der aufgenommenen Chips nacheinander durchgeführt werden müssen. Außerdem ist es bei beiden Vorschlägen erforderlich, eine diskontinuierliche Bewegung in einer ersten Richtung zum Aufnehmen der entsprechenden Chips und in einer entgegengesetzten zweiten Richtung zum Zurückkehren des Entnahmewerkzeuges in seine Ausgangsstellung durchzuführen. Bei den heutigen Bestückvorrichtungen und Bestücksystemen, welche auf hohen Durchsatz ausgelegt sind, wirken derartige Nachteile jedoch stark leistungsmindernd.

Die Druckschrift JP 08-162502 offenbart eine Bestückungsvorrichtung, welche einen Ejektor, ein Entnahmewerkzeug und ein Bestückungswerkzeug aufweist. Mit dem Ejektor wird ein vereinzelter Chip von einer klebrigen Waferfolie abgelöst und an einen Vakuumgreifer des Entnahmewerkzeuges übergeben. Nach einer Drehung des Entnahmewerkzeuges um 180°, bei welcher der Chip lediglich entlang eines Halbkreises ohne Veränderung seiner Orientierung (d.h. ohne Wenden) bewegt wird, wird der Chip an einen Vakuumgreifer des Bestückungswerkzeuges übergeben. Der Vakuumgreifer ist dabei antiparallel zu dem Vakuumgreifer orientiert, so dass der Chip vor der Übergabe an seiner Unterseite von dem Vakuumgreife und nach der Übergabe an seiner Oberseite von dem Vakuumgreifer gehalten wird. Nach einer Drehung des Bestückungswerkzeuges um 180°, bei welcher der Chip erneut entlang eines Halbkreises ohne Veränderung seiner Orientierung (d.h. ohne Wenden) bewegt wird, wird der Chip auf einen Schaltungsträger aufgesetzt.

Die US 4,626,167 offenbart eine Handhabungsvorrichtung für Chips. Die Handhabungsvorrichtung weist einen Zylinder auf, welcher um eine Drehachse drehbar ist. Die Handhabungsvorrichtung weist ferner radial abstehend von dem Zylinder vier Sauggreifer auf, welche zur Aufnahme jeweils eines Chips vorgesehen sind. Wenn sich ein Sauggreifer in einer oberen ("0 Uhr") Position befindet, kann er mit Unterstützung eines Ejektorkopfes jeweils einen vereinzelten Chip von einem Wafer übernehmen. Nach einer Drehung des Zylinders um 180°, bei der der Chip um 180° gewendet wird, kann der Chip auf einen Bauelementträger aufgesetzt werden.

Die US 4,372,802 offenbart eine Vorrichtung zum Bestücken von Leiterplatten mit Chips. Ein Bestückungswerkzeug der Vorrichtung weist, um eine Drehachse radial abstehend, acht Bestückköpfe auf, die jeweils eine Saugpipette umfassen. Wenn sich eine Saugpipette in einer oberen ("0 Uhr") Position befindet, kann sie von einer Palette jeweils einen Chip aufnehmen. Nach einer Drehung des Bestückungswerkzeuges um 180°, bei welcher der Chip um 180° gewendet wird, kann der Chip auf eine Leiterplatte 3 aufgesetzt werden.

Die WO 00/69241 A1 offenbart einen Bestückungsautomaten zum Entnehmen von Chips von strukturierten Halbleiter-Wafern und zum Bestücken einer Leiterplatte mit den entnommenen Chips. Der Bestückungsautomat weist ein Entnahmewerkzeug auf, welches um eine Drehachse drehbar ist. An einem Grundkörper des Entnahmewerkzeugs sind radial abstehend vier Wendeköpfe angebracht, welche jeweils einen Chip aufnehmen können. Die Wendeköpfe sind jeweils um eine senkrecht zur Drehachse B orientierte Wendeachse drehbar, wobei die Wendebewegung durch die Wendköpfe durch einen Nockenfolger mit der Drehung des Entnahmewerkzeug derart korreliert ist, dass sich ein an einer Übergabeposition befindlicher Wendekopf im Vergleich zu seiner Chip-Aufnahmeposition a gerade um 180 0 gedreht hat. Das gleich gilt auch für die Chips, welche von einer Saugpipette des Wendekopfes gehalten wurden. An der Übergabeposition wird der Chip dann von einem Bestückungswerkzeug übernommen, welches vier jeweils mit einer Saugpipette 40 ausgestattete Bestückköpfe aufweist. Die Bestückköpfe sind radial abstehend an einem Grundkörper angebracht, welcher zusammen mit den Bestückköpfen um eine weitere Drehachse drehbar ist. Im Gegensatz zu den Wendeköpfen drehen sich die Bestückköpfe bei einer Drehung des Bestückungswerkzeuges jedoch nicht um jeweils eine senkrecht zur weiteren Drehachse orientierte Achse. Die Chips werden von den Wendeköpfen des Entnahmewerkzeuges einmal um 180 gedreht.

JP 2-193813 A offenbart ein Verfahren und eine Vorrichtung zum Invertieren von elektronischen Vorrichtungen. EP 0 906 011 A2 offenbart eine Vorrichtung zum Bestücken von flachen Bauelementeträgern mit elektrischen Bauelementen.

Es ist eine Aufgabe der Erfindung, eine umfassende optische Inspektion eines ungewendet zu bestückenden Chips zu ermöglichen.

Diese Aufgabe wird gelöst durch eine Chipentnahmevorrichtung, ein Chipentnahmesystem und ein Bestücksystem mit den Merkmalen der unabhängigen Patentansprüche 1, 7 bzw. 9.

Bevorzugte Ausgestaltungen der Erfindung sind in den abhängigen Ansprüchen beansprucht.

Erfindungsgemäß wird eine Chipentnahmevorrichtung zum Entnehmen von Chips von strukturierten Halbleiter-Wafern geschaffen, welche ein Entnahmewerkzeug zum Entnehmen der Chips von dem Wafer und zum Wenden der entnommenen Chips um 180° um ihre Längs- oder Querachse sowie ein Wendewerkzeug zum erneuten Wenden der entnommenen Chips um 180° um ihre Längs- oder Querachse aufweist, wobei das Entnahmewerkzeug eine erste Übergabeposition und das Wendewerkzeug eine zweite Übergabeposition aufweist, an welche die Chips zur Weiterverarbeitung an einen Bestückkopf übergebbar sind. Mit der erfindungsgemäßen Chipentnahmevorrichtung ist es möglich, in einem kontinuierlichen Betrieb Chips von einem Wafer aufzunehmen und gewendet oder ungewendet an einer Übergabeposition zur weiteren Verarbeitung, beispielsweise an einen Bestückkopf eines Bestücksystems, zu übergeben. Hierdurch ist ein kontinuierlicher Betrieb der Chipentnahmevorrichtung mit hoher Stückleistung möglich.

Beispielsweise können das Entnahmewerkzeug und das Wendewerkzeug jeweils eine Mehrzahl von Greifern aufweisen, mittels welchen die Chips von dem Wafer entnommen werden können und von welchen die Chips während des Wendens gehalten werden.

Die Greifer des Entnahmewerkzeugs und des Wendewerkzeugs sind jeweils rotationssymmetrisch um eine gemeinsame Drehachse drehbar angeordnet. Hierdurch kann beispielsweise an einer Stelle mit einem Greifer des Entnahmewerkzeugs ein Chip aufgenommen werden, während gleichzeitig an einem anderen Greifer ein dort gehaltener Chip zum Übergeben bereitgestellt werden kann.

Die Drehrichtung des Entnahmewerkzeugs kann zu der Drehrichtung des Wendewerkzeugs entgegengesetzt sein. Hierdurch können beispielsweise an dem Wendewerkzeug eine der Mehrzahl von Greifern des Wendewerkzeugs entsprechende Mehrzahl von Chips zwischengespeichert werden.

Es ist möglich, die erste Übergabeposition und die zweite Übergabeposition in einer Ebene anzuordnen. Hierdurch können sowohl gewendete Chips als auch ungewendete Chips in einer einzigen Ebene zum Übergeben bereitgestellt werden, wodurch ein schnelles Abholen von gewendeten und von ungewendeten Chips von der ersten bzw. von der zweiten Übergabeposition, beispielsweise mittels eines Bestückkopfs eines Bestücksystems, möglich ist.

Um das Zusammenwirken des Entnahmewerkzeugs mit dem Wendewerkzeug zu ermöglichen, ist eine gemeinsame dritte Übergabeposition zwischen dem Entnahmewerkzeug und dem Wendewerkzeug vorgesehen. Die dritte Übergabeposition ist dabei in einem Bereich geringsten Abstands zwischen dem Entnahmewerkzeug und dem Wendewerkzeug angeordnet. Hierdurch ist es möglich, mittels des Entnahmewerkzeugs entnommene Chips an das Wendewerkzeug zu übergeben und hierdurch erneut zu wenden.

Durch kontinuierliches Drehen sowohl des Entnahmewerkzeugs, als auch des Wendewerkzeugs ist ein kontinuierlicher Betrieb mit der erfindungsgemäßen Chipentnahmevorrichtung möglich. Hierdurch sind ein hoher Durchsatz sowie ein flexibles Bereitstellen von sowohl gewendeten als auch ungewendeten Chips zum Übergeben möglich.

Erfindungsgemäß wird auch ein Chipentnahmesystem geschaffen, welches eine Chipentnahmevorrichtung, wie oben beschrieben, aufweist und ferner mit einem Ejektor versehen, von welchem die von dem Wafer zu entnehmenden Chips angehoben werden können. Beispielsweise ist der Ejektor dem Entnahmewerkzeug bezüglich des Wafers gegenüberliegend angeordnet. Hierdurch kann vor dem Entnehmen der Chips durch die Greifer des Entnahmewerkzeugs der jeweilige Chip angehoben werden, so dass das Entnehmen erleichtert wird.

Es ist auch möglich, zusätzlich ein Bildverarbeitungssystem vorzusehen, mittels welchem Bildinformationen über an den Greifern des Entnahmewerkzeugs und/oder des Wendewerkzeugs gehaltenen Chips zu ermitteln. Hierzu ist das Bildverarbeitungssystem seitlich des Entnahmewerkzeugs und/oder seitlich des Wendewerkzeugs angeordnet, so dass es die gehaltenen Chips zumindest in einer seitlichen Ansicht oder in einer Draufsicht erfassen kann. Hierdurch ist es möglich, während des kontinuierlichen Betriebs ohne Zeitverlust den korrekten Sitz der entnommenen Chips an den entsprechenden Greifern zu überprüfen bzw. nachzuvollziehen, ob der richtige Chip-Typ von dem Wafer entnommen wurde.

Die erfindungsgemäße Chipentnahmevorrichtung kann auch in einem Bestücksystem als Bestückkopf verwendet werden. Hierbei sind eine Aufnahmeposition, an welcher die Chips von dem Wafer aufgenommen werden bzw. entnommen werden und die erste und die zweite Übergabeposition und der Chipentnahmevorrichtung in einer Ebene angeordnet. Es ist jedoch auch möglich, die Aufnahmeposition und die beiden Übergabepositionen in unterschiedlichen Ebenen anzuordnen. Hierdurch ist ein Entnehmen mittels des erfindungsgemäßen Bestückkopfs von Chips von einem Wafer aus unterschiedlichen Lagen des Wafers möglich, wobei mittels desselben Bestückkopfs die entnommenen Chips auf ein beispielsweise horizontal ausgerichtetes Substrat bestückt werden können.

Es ist auch möglich, die Aufnahmeposition mit der ersten Übergabeposition zusammenzulegen. Bei dieser Ausführungsform werden die entnommenen Chips an derselben Position des Entnahmewerkzeugs, an welcher sie von dem Wafer entnommen wurden, auch an das zu bestückende Substrat abgegeben.

Wie das erfindungsgemäße Chipentnahmesystem kann auch das Bestücksystem mit einem Ejektor versehen sein. Ferner kann das Bestücksystem auch ein Bildverarbeitungssystem, ähnlich dem Bildverarbeitungssystem des erfindungsgemäßen Chipentnahmesystems aufweisen.

Erfindungsgemäß sind zwei unterschiedliche Betriebsarten möglich. Einerseits kann mit jedem Entnehmen eines Chips von dem Wafer ein Übergeben eines anderen bereits entnommenen Chips an die Handhabungseinrichtung erfolgen. Hierbei handelt es sich um eine vollständig kontinuierliche Betriebsweise. Diese ist beispielsweise vorteilhaft bei einem feststehenden Bestückkopf eines Bestücksystems, dem die entnommenen Chips zugeführt werden sollen. Aufgrund der festen örtlichen Anordnung des Bestückkopfs ist allerdings ein Bewegen des Wafers zum Entnehmen der Vielzahl von auf dem Wafer angeordneten Chips erforderlich.

Um das Übergeben bzw. das Entnehmen und das Bereitstellen an der Übergabeposition mittels der an den erfindungsgemäßen Vorrichtungen vorgesehenen Greifer zu erleichtern, können die Greifer beispielsweise in radialer Richtung des Entnahmewerkzeugs bzw. des Wendewerkzeugs bewegbar an dem Entnahmewerkzeug bzw. an dem Wendewerkzeug angeordnet sein. Insbesondere sind die Greifer Vakuumpipetten.

Die Drehung des Entnahmewerkzeugs bzw. des Wendewerkzeugs erfolgt beispielsweise in indizierten Bewegungsschritten, d. h. in einheitlichen Winkel-Schritten. Diese indizierte Bewegung wird beispielsweise jeweils in einer einzigen Drehrichtung des Entnahmewerkzeugs und einer einzigen Drehrichtung des Wendewerkzeugs derart durchgeführt, dass an anderen als den Aufnahmepositionen und den Übergabepositionen des Entnahmewerkzeugs und des Wendewerkzeugs weitere Bearbeitungsschritte, wie beispielsweise das Vermessen der entnommenen Chips mittels eines Bildverarbeitungssystems, parallel zu dem Entnehmen, Transportieren und Bereitstellen an der Übergabeposition durchgeführt werden kann, wodurch die Verarbeitungszeit aufgrund der Parallelisierung von Einzelschritten stark absinkt.

Die Greifer des Entnahmewerkzeugs und des Wendewerkzeugs können jeweils voneinander unabhängig individuell in ihrer radialen Position eingestellt werden. Beispielsweise kann die Erfindung mit einem Zuführmodul für Bauelemente, wie es in Bestückvorrichtungen verwendet wird, eingesetzt werden. Es ist möglich, sowohl horizontal als auch vertikal angeordnete Wafer zu verarbeiten. Ferner kann der Wafer bewegt oder stillstehend angeordnet sein.

Im Falle des COB-Prozesses werden die entnommenen Chips von dem Entnahmewerkzeug an das Wendewerkzeug übergeben und von diesem erneut gewendet, so dass sie wieder in den ungewendeten Zustand gebracht werden. Von dem Wendewerkzeug können sie dann an dessen zweiter Übergabeposition mittels des Bestückkopfs in ungewendetem Zustand entnommen werden.

Während gewendete Chips bei einem Bestücksystem beispielsweise an dem Bestückkopf mit einer Bauelementekamera vermessen werden können, ist die einzige Möglichkeit zum Vermessen von ungewendeten Chips an einer Position, an der sie sich noch an dem Wendewerkzeug befinden. Daher kann erfindungsgemäß das Vermessen von ungewendeten Chips des COB-Prozesses durch Vorsehen eines zusätzlichen Bildverarbeitungssystems an dem Wendewerkzeug realisiert werden.

Der oben beschriebene kontinuierliche Betriebsmodus ist insbesondere vorteilhaft, wenn die Zeit, welche zum Entnehmen eines Chips von dem Wafer erforderlich ist, im Wesentlichen die gleiche Zeit ist, welche verbraucht wird, um den entnommenen Chip an einen Bestückkopf zu übergeben. Hierbei kann ein bewegter Wafer sowie ein stationärer Bestückkopf erforderlich sein. Das Übergeben des entnommenen Chips an den Bestückkopf kann hierbei parallel zum Entnehmen durchgeführt werden, wodurch ein kontinuierlicher hochparalleler Betrieb möglich ist.

Bei einer flexibleren Betriebsart nimmt zunächst das Entnahmewerkzeug die entnommenen Chips auf und hält eine Mehrzahl dieser Chips, während der Bestückkopf des Bestücksystems noch seine Bestückoperationen durchführt. Danach werden beide bezüglich einer gemeinsamen Übergabeposition, beispielsweise der ersten Übergabeposition des Entnahmewerkzeugs oder der zweiten Übergabeposition des Wendewerkzeugs aneinandergeführt. Durch schrittweises Bewegen des Entnahmewerkzeugs und/oder des Wendewerkzeugs ist ein für diesen Zeitraum kontinuierliches Übertragen der entnommenen Chips von dem Entnahmewerkzeug bzw. von dem Wendewerkzeug an den Bestückkopf möglich. Hierdurch wird die Übertragungszeit zum Übertragen der entnommenen Chips von dem erfindungsgemäßen Chipentnahmesystem bzw. der erfindungsgemäßen Chipentnahmevorrichtung an einen Bestückkopf minimiert. Hierbei kann die Anzahl der insgesamt an dem erfindungsgemäßen Chipentnahmesystem bzw. der erfindungsgemäßen Chipentnahmevorrichtung vorgesehenen Greifer, welche entnommene Chips aufnehmen können, größer oder gleich der Anzahl von Greifern sein, welche an dem Bestückkopf vorgesehen sind.

Die Erfindung wird unter Bezugnahme auf die Zeichnung näher erläutert. In der Zeichnung zeigt die

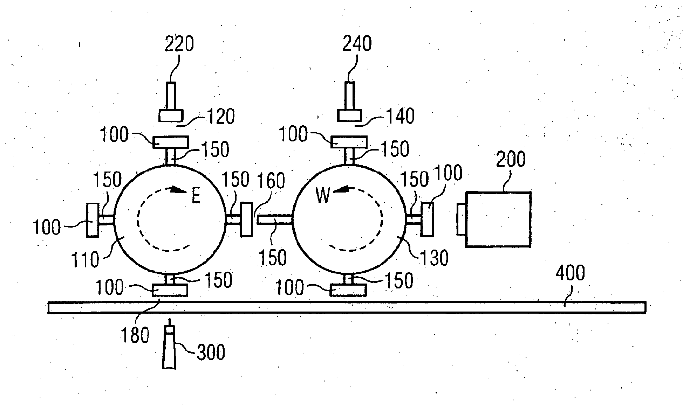

Figur 1 eine bevorzugte Ausführungsform des erfindungsgemäßen Chipentnahmesystems.

Wie aus der Figur 1 ersichtlich, weist eine bevorzugte Ausführungsform der Erfindung ein (Entnahmewerkzeug110, ein Wendewerkzeug 130 sowie eine Mehrzahl von Greifern 150 auf, an welchen Chips 100, welche von einem Wafer 400 entnommen werden, gehalten werden können. Das Entnahmewerkzeug 110 weist eine erste Übergabeposition 120 und eine Aufnahmeposition 180 auf. An der Aufnahmeposition 180 können von dem Wafer 400 zu entnehmende Chips 100 mittels des an der Aufnahmeposition 180 befindlichen Greifers des Entnahmewerkzeugs 110 aufgenommen werden. Dies ist einerseits möglich durch Absenken des Greifers 150, indem dieser radial zu dem Entnahmewerkzeug 110 bewegt wird. Andererseits kann mittels eines Ejektors 300, welcher der Aufnahmeposition 180 bezüglich des Wafers 400 gegenüberliegend dem Entnahmewerkzeug 110 angeordnet ist, der zu entnehmende Chip 100 in Richtung auf den Greifer 150 in der Aufnahmeposition 180 zubewegt wird und an diesem gehalten wird. Es ist auch eine Kombination der beiden vorgenannten Entnahmemöglichkeiten für Chips 100 von dem Wafer 400 möglich.

Wie aus der Figur ersichtlich, sind nach der bevorzugten Ausführungsform der Erfindung beispielsweise vier Greifer 150 an dem Entnahmewerkzeug 110 sowie vier Greifer 150 an dem Wendewerkzeug 130 vorgesehen. Das indizierte Bewegen des Entnahmewerkzeugs 110 in der Drehrichtung E sowie das indizierte Bewegen des Wendewerkzeugs 130 in der Drehrichtung W des Wendewerkzeugs erfolgt daher jeweils in 90°-Schritten. Bei einer anderen Anzahl von Greifern 150 an dem Entnahmewerkzeug 110 bzw. an dem Wendewerkzeug 130 ist eine entsprechend andere winkelschrittweise Bewegung des Entnahmewerkzeugs 110 bzw. des Wendewerkzeugs 130 vorgesehen. Es ist auch möglich, die Anzahlen von Greifern 150 an dem Entnahmewerkzeug 110 unterschiedlich von jenen des Wendewerkzeugs 130 auszubilden. Daher sind auch unterschiedliche Winkelschritte möglich.

Durch Drehen des Entnahmewerkzeugs 110 gelangen die entnommenen Chips 100, welche von den Greifern 150 gehalten werden, an die erste Übergabeposition 120 des Entnahmewerkzeugs 110. Hier können sie in einer um 180° gewendeten Lage beispielsweise von einem Greifer 220 eines Bestückkopfs eines Bestücksystems entnommen werden.

Es ist auch möglich, die entnommenen Chips 100 von der ersten Übergabeposition 120 noch um einen Winkelschritt an eine dritte, gemeinsame Übergabeposition 160 des Entnahmewerkzeugs 110 und des Wendewerkzeugs 130 zu transportieren, wo der entnommene Chip 100 von dem Greifer 150 des Entnahmewerkzeugs 110 an einen Greifer 150 des Wendewerkzeugs 130 übergeben werden kann, welcher sich ebenfalls an der dritten Übergabeposition 160 befindet. Durch das erneute Übergeben des entnommenen Chips 100 und Drehen desselben in der Drehrichtung W des Wendewerkzeugs 130 in die zweite Übergabeposition 140 des Wendewerkzeugs 130 kann ein entnommener Chip 100 in einem ungewendeten Zustand zum Übergeben an einen Greifer 240 eines Bestückkopfs eines Bestücksystems in der zweiten Übergabeposition 140 bereitgestellt werden.

Es ist beispielsweise auch möglich, ein Bildverarbeitungssystem 200 seitlich des Wendewerkzeugs 130 vorzusehen, mittels welchem die in einem ungewendeten Zustand an den Greifer 150 an dem Wendewerkzeug 130 gehaltenen Chips 100 hinsichtlich ihrer Lage und ihres Typs zu überprüfen.

Ferner kann noch ein Bildverarbeitungssystem (nicht gezeigt) seitlich des Entnahmewerkzeugs 110 zum Überprüfen der Lage und des Typs der an den Greifern 150 des Entnahmewerkzeugs 110 gehaltenen und in einem gewendeten Zustand befindlichen entnommenen Chips 100 vorgesehen sein.

## Patentansprüche

1. Chipentnahmevorrichtung zum Entnehmen von Chips (100) von strukturierten Halbleiter-Wafern, mit
• einem drehbaren Entnahmewerkzeug (110) zum Entnehmen der Chips (100) von dem Wafer (400) und zum Wenden der entnommenen Chips (100) um 180° um ihre Längs- oder Querachse, und
• einem drehbaren Wendewerkzeug (130) zum erneuten Wenden der entnommenen Chips (100) um 180° um ihre Längs- oder Querachse, welches mit dem Entnahmewerkzeug (110) zusammenwirkt,
• wobei das Entnahmewerkzeug (110) eine erste Übergabeposition und das Wendewerkzeug (130) eine zweite Übergabeposition (140) aufweist, an welchen die Chips (100) zur Weiterverarbeitung an einen Bestückkopf (220, 240) übergebbar sind,
• wobei das drehbare Wendewerkzeug (130) mit dem Entnahmewerkzeug (110) an einer dritten, gemeinsamen Übergabeposition (160) des Entnahmewerkzeugs (110) und des Wendewerkzeugs (130) zusammenwirkt,
• wobei die dritte, gemeinsame Übergabeposition (160) des Entnahmewerkzeugs (110) und des Wendewerkzeugs (130) in einem Bereich geringsten Abstands zwischen dem Entnahmewerkzeug (110) und dem Wendewerkzeug (130) vorgesehen ist, an welcher erneut zu wendende Chips (100) von dem Entnahmewerkzeug (110) an das Wendewerkzeug (130) übergebbar sind.

2. Chipentnahmevorrichtung nach Anspruch 1, wobei
• das Entnahmewerkzeug (110) und das Wendewerkzeug (130) jeweils eine Mehrzahl von Greifern (150) zum Greifen der Chips (100) aufweisen, welche jeweils rotationssymmetrisch um eine gemeinsame Drehachse drehbar angeordnet sind.

3. Chipentnahmevorrichtung nach Anspruch 2, wobei
• die Drehrichtung (E) des Entnahmewerkzeugs (110) der Drehrichtung (W) des Wendewerkzeugs entgegengesetzt ist.

4. Chipentnahmevorrichtung nach einem der Ansprüche 1 bis 3, wobei
• die erste Übergabeposition (120) und die zweite Übergabeposition (140) in einer Ebene angeordnet sind.

5. Chipentnahmevorrichtung nach Anspruch 2 bis 4, wobei
• die Greifer (150) Vakuumpipetten sind.

6. Chipentnahmevorrichtung nach einem der Ansprüche 1 bis 5, wobei das Entnahmewerkzeug (110) und das Wendewerkzeug (130) für einen kontinuierlichen Betrieb ausgelegt sind.

7. Chipentnahmesystem mit einer Chipentnahmevorrichtung nach einem der Ansprüche 1 bis 6, ferner mit
• einem Ejektor (300) zum Anheben der von dem Wafer (400) zu entnehmenden Chips (100), welcher dem Entnahmewerkzeug (110) bezüglich des Wafers (400) gegenüberliegend angeordnet ist.

8. Chipentnahmesystem nach Anspruch 7, ferner mit
• einem Bildverarbeitungssystem, welches seitlich des Entnahmewerkzeugs (110) und/oder seitlich des Wendewerkzeugs (130) angeordnet ist, und von welchem Bildinformationen über an den Greifern (150) gehaltene Chips (100) ermittelbar sind.

9. Bestücksystem zum Bestücken von Bauelementen auf Substrate, bei welchem
• als Bestückkopf (220, 240) eine Chipentnahmevorrichtung nach einem der Ansprüche 1 bis 6 vorgesehen ist.

10. Bestücksystem nach Anspruch 9, bei welchem
• eine Aufnahmeposition (180), an welcher die Chips (100) mittels des Entnahmewerkzeugs (110) aufnehmbar sind und die erste und die zweite Übergabeposition (120, 140) in einer Ebene angeordnet sind.

11. Bestücksystem nach Anspruch 10, bei welchem
• die Aufnahmeposition (180) der ersten Übergabeposition (120) entspricht.

12. Bestücksystem nach Anspruch 9 bis 11, ferner mit
• einem Ejektor (300) zum Anheben der von dem Wafer (400) zu entnehmenden Chips (100), welcher der Aufnahmeposition (180) bezüglich des Wafers (400) gegenüberliegend angeordnet ist.

13. Bestücksystem nach einem der Ansprüche 9 bis 12 ferner mit
• einem Bildverarbeitungssystem, welches seitlich des Entnahmewerkzeugs (110) und/oder seitlich des Wendewerkzeugs (130) angeordnet ist, und von welchem Bildinformationen über an den Greifern (150) gehaltene Chips (100) ermittelbar sind.

## Claims

1. A chip removal device for removing chips (100) from structured semiconductor wafers, the chip removal device comprising
a rotatable removing tool (110) for removing the chips (100) from the wafer (400) and for turning the removed chips (100) about 180° around their longitudinal or transversal axis, and
a rotatable turning tool (130) for again turning the removed chips (100) about 180° around their longitudinal or transversal axis, wherein the rotatable turning tool (130) cooperates with the removing tool (110),
wherein the removing tool (110) comprises a first transfer position and the turning tool (130) comprises a second transfer position to which transfer positions the chips (100) can be transferred to a mounting head (220, 240) for further processing,
wherein the rotatable turning tool (130) cooperates with the removing tool (110) at a third common transfer position (160) of the removing tool (110) and of the turning tool (130),
wherein the third common transfer position (160) of the removing tool (110) and of the turning tool (130) is provided in a region with the smallest distance between the removing tool (110) and the turning tool (130), at which chips (100), which are supposed to be turned again, are transferable from the removing tool (110) to the turning tool (130).

2. The chip removal device as set forth in claim 1, wherein
the removing tool (110) and the turning tool (130) each comprise a plurality of picking devices (150) for picking up the chips (100), which picking devices (150) are respectively arranged in a rotational symmetric manner around a common rotational axis.

3. The chip removal device as set forth in claim 2, wherein
the rotational direction (E) of the removing tool (110) is opposite to the rotational direction (W) of the turning tool (130).

4. The chip removal device as set forth in one of the claims 1 to 3, wherein the first transfer position (120) and the second transfer position (140) are arranged in one plane.

5. The chip removal device as set forth in one of the claims 2 to 4, wherein the picking devices (150) are suction nozzles.

6. The chip removal device as set forth in any one of the claims 1 to 5, wherein
the removing tool (110) and the turning tool (130) are designed for a continuous operation.

7. The chip removal device as set forth in any one of the claims 1 to 6, further comprising
an ejector (300) for raising the chips (100) which are supposed to be removed from the wafer (400), which ejector (300) is arranged opposite to the removing tool (110) with respect to the wafer (400).

8. The chip removal device as set forth in claim 7, further comprising
an image processing system which is arranged laterally with respect to the removing tool (110) and/or laterally with respect to the turning tool (130), and by which image processing system image information about chips (100) which are held by the picking up devices (150) are determinable.

9. An assembly system for assembling components onto substrates, wherein
a chip removal device as set forth in any one of the claims 1 to 6 is provided as mounting head (220, 240).

10. The assembly system as set forth in claim 9, wherein
a receiving position (180), at which the chips (100) are receivable by means of the removing tool (110) and the first transfer position (120) and the second transfer position (140) are located within one plane.

11. The assembly system as set forth in claim 10, wherein
the receiving position (180) corresponds to the first transfer position (120).

12. The assembly system as set forth in any one of the claims 9 to 11, further comprising
an ejector (300) for raising the chips (100) which are supposed to be removed from the wafer (400), which ejector (300) is arranged opposite to the receiving position (180) with respect to the wafer (400).

13. The assembly system as set forth in any one of the claims 9 to 12, further comprising
an image processing system which is arranged laterally with respect to the removing tool (110) and/or laterally with respect to the turning tool (130), and by which image processing system image information about chips (100) which are held by the picking up devices (150) are determinable.

## Revendications

1. Dispositif de prélèvement de puces pour prélever des puces (100) de plaquettes semi-conductrices structurées, avec
un outil de prélèvement rotatif (110) pour prélever les puces (100) de la plaquette (400) et pour retourner les puces (100) prélevées de 180° autour de leur axe transversal ou longitudinal, et
un outil de retournement rotatif (130) pour le retournement renouvelé des puces prélevées (100) de 180° autour de leur axe transversal ou longitudinal, lequel coopère avec l'outil de prélèvement (110),
dans lequel l'outil de prélèvement (110) présente une première position de transfert et l'outil de retournement (130) présente une deuxième position de transfert (140), au niveau desquelles les puces (100) peuvent être transférées pour la suite du traitement à l'attention d'une tête d'équipement (220, 240), dans lequel l'outil de retournement (130) coopère avec l'outil de prélèvement (110) à une troisième, commune position de transfert (160) de l'outil de prélèvement (110) et de l'outil de retournement (130),
dans lequel la troisième, commune position de transfert (160) de l'outil de prélèvement (110) et de l'outil de retournement (130) est prévue dans une zone d'espacement minimal entre l'outil de prélèvement (110) et l'outil de retournement (130), au niveau de laquelle des puces (100) à retourner de nouveau peuvent être transférées par l'outil de prélèvement (110) à l'outil de retournement (130).

2. Dispositif de prélèvement de puces selon la revendication 1, dans lequel l'outil de prélèvement (110) et l'outil de retournement (130) présentent respectivement une pluralité d'outils de préhension (150) pour saisir les puces (100), lesquels sont respectivement disposés en symétrie de rotation autour d'un axe de rotation commun.

3. Dispositif de prélèvement de puces selon la revendication 2, dans lequel le sens de rotation (E) de l'outil de prélèvement (110) est opposé au sens de rotation (W) de l'outil de retournement.

4. Dispositif de prélèvement de puces selon l'une des revendications 1 à 3, dans lequel
la première position de transfert (120) et la deuxième position de transfert (140) sont disposées dans un plan.

5. Dispositif de prélèvement de puces selon les revendications 2 à 4, dans lequel
les outils de préhension (150) sont des pipettes à vide.

6. Dispositif de prélèvement de puces selon l'une des revendications 1 à 5, dans lequel l'outil de prélèvement (110) et l'outil de retournement (130) sont étudiés pour un fonctionnement en continu.

7. Système de prélèvement de puces avec un dispositif de prélèvement de puces selon l'une des revendications 1 à 6, avec en outre un éjecteur (300) pour soulever les puces (100) à prélever de la plaquette (400), lequel est disposé en vis-à-vis de l'outil de prélèvement (110) compte tenu de la plaquette (400).

8. Système de prélèvement de puces selon la revendication 7, avec en outre
un système de traitement d'image, lequel est disposé sur le côté de l'outil de prélèvement (110) et/ou sur le côté de l'outil de retournement (130), et grâce auquel des informations d'image concernant des puces (100) tenues au niveau des outils de préhension (150) peuvent être déterminées.

9. Système d'équipement pour l'équipement de composants sur des substrats, dans le cadre duquel
on prévoit, en guise de tête d'équipement (220, 240), un dispositif de prélèvement de puces selon l'une des revendications 1 à 6.

10. Système d'équipement selon la revendication 9, dans le cadre duquel une position de réception (180), au niveau de laquelle les puces (100) peuvent être réceptionnées à l'aide de l'outil de prélèvement (110), et la première et la deuxième position de transfert (120, 140), sont disposées dans un plan.

11. Système d'équipement selon la revendication 10, dans le cadre duquel la position de réception (180) correspond à la première position de transfert (120).

12. Système d'équipement selon les revendications 9 à 11, avec en outre un éjecteur (300) pour soulever les puces (100) à prélever de la plaquette (400), lequel est disposé en vis-à-vis de la position de réception (180) compte tenu de la plaquette (400).

13. Système d'équipement selon l'une des revendications 9 à 12 avec en outre un système de traitement d'image, lequel est disposé sur le côté de l'outil de prélèvement (110) et/ou sur le côté de l'outil de retournement (130), et grâce auquel des informations d'image concernant des puces (100) tenues au niveau des outils de préhension (150) peuvent être déterminées.
